# EUROPÄISCHE PATENTSCHRIFT

(11) **EP 4 351 880 B1**
(45) Veröffentlichungstag und Bekanntmachung des Hinweises auf die Patenterteilung: **21.05.2025**
(21) Anmeldenummer: 22735803.3
(22) Anmeldetag: 10.06.2022
(51) Int. Cl.: B41F 15/08, B41F 15/44, B41F 33/00, H05K 3/12

(54) **DRUCKVORRICHTUNG UND VERFAHREN ZUM BEDRUCKEN VON SUBSTRATEN**
PRINTING DEVICE AND METHOD FOR PRINTING ONTO SUBSTRATES
DISPOSITIF D'IMPRESSION ET PROCÉDÉ D'IMPRESSION SUR DES SUBSTRATS

(30) Priorität: 11.06.2021 DE 102021205984
(43) Veröffentlichungstag der Anmeldung: 17.04.2024
(73) Patentinhaber: Ekra Automatisierungssysteme GmbH, 74357 Bönnigheim (DE)
(72) Erfinder: PLACHY, Franz, 74336 Brackenheim (DE); SÄNGER, Lukas, 71522 Backnang (DE); VOIGT, Rainer, 79104 Freiburg (DE)
(74) Vertreter: Clarenbach, Carl-Philipp
(86) Internationale Anmeldenummer: PCT/EP2022/065877
(87) Internationale Veröffentlichungsnummer: WO 2022/258823

(56) Entgegenhaltungen:
- IT-A1- UD20 090 153
- US-A1- 2002 020 346
- US-A1- 2014 109 779

## Beschreibung

Die Erfindung betrifft eine Druckvorrichtung zum Bedrucken von Substraten, insbesondere Solarzellen, Wafer, Leiterplatten oder dergleichen, mit einer Rakeleinrichtung und mit zumindest einem Drucktisch, wobei die Rakeleinrichtung oberhalb des Drucktischs angeordnet ist, und mit zumindest einer dem Drucktisch angeordneten Fördereinrichtung, mittels welcher jeweils ein Substrat auf ein Drucknest unterhalb der Rakeleinrichtung und aus dem Drucknest nach erfolgtem Druckvorgang weg transportierbar ist.

Weiterhin betrifft die Erfindung ein Verfahren zum Bedrucken von Substraten, insbesondere Wafer, Solarzellen, Leiterplatten oder dergleichen, mit einer Rakeleinrichtung und mit zumindest einem Drucktisch, wobei die Rakeleinrichtung oberhalb des Drucktischs angeordnet ist, und wobei ein zu bedruckendes Substrat auf ein Drucknest des Drucktischs gefördert, bedruckt und anschließend von dem Drucknest weg transportiert wird.

Druckvorrichtungen der eingangs genannten Art sind aus dem Stand der Technik bereits bekannt. Druckeinrichtungen, die eine Rakeleinrichtung zum Bedrucken von Substraten nutzen, können vielseitig eingesetzt werden. Insbesondere werden sie dazu genutzt, auf elektrisch nicht-leitfähigen Substraten elektrisch leitfähige Leiterbahnen zu drucken, beispielsweise um Leiterplatten oder Solarzellen oder dergleichen herzustellen. Bei dem Rakelvorgang wird zunächst eine Druckmasse auf ein Drucksieb aufgetragen, das oberhalb des zu bedruckenden Substrats liegt. Anschließend wird mit einem Rakel, das insbesondere eine Rakelklinge aufweist, die Druckmasse durch das Drucksieb hindurch auf das Substrat gepresst. Optional wird dazu das Substrat nahe zu dem Drucksieb angehoben, um einen vorbestimmten Absprung, also einen vorbestimmten Abstand zwischen Drucksieb und der zu bedruckenden Substratoberfläche, einzustellen. Zur Fixierung des Substrats wird in der Regel ein Drucknest verwendet. Beispielsweise in der der Offenlegungsschrift IT DU20 090 153 A1 wird eine herkömmliche Druckvorrichtung beschrieben.

Weil für den Rakelvorgang das Drucksieb und das Substrat fest zueinander zugeordnet sein müssen, ist der Rakelvorgang nicht beliebig beschleunigbar. Um jedoch den Durchsatz einer derartigen Druckvorrichtung zu erhöhen, ist es beispielsweise aus der Offenlegungsschrift DE 10 2018 205 944 bekannt, mehrere Substrate einem Drucknest gleichzeitig zuzuführen und mit einem Drucksieb, das für jedes der Substrate ein Druckmuster aufweist, in einem Rakelvorgang zu bedrucken.

Aus der Offenlegungsschrift US 2014/109779 A1 ist eine Druckvorrichtung mit einem Drucksieb bekannt, das wahlweise einem ersten oder einem zweiten Drucknest zuordenbar ist. Die Offenlegungsschrift US 2002/020346 A1 beschreibt eine Druckvorrichtung mit einem Drucksieb, das sich über mehrere Drucknester hinweg erstreckt.

Der vorliegenden Erfindung liegt die Aufgabe zugrunde, den Druckvorgang weiter zu beschleunigen, ohne dabei Qualitätseinbußen im Druckresultat hinnehmen zu müssen.

Die der Erfindung zugrundeliegende Aufgabe wird durch eine Druckvorrichtung mit den Merkmalen des Anspruchs 1 gelöst. Die erfindungsgemäße Druckvorrichtung hat den Vorteil, dass ohne großen Mehraufwand, eine kontinuierliche oder zumindest kontinuierlichere Bearbeitung der Substrate durch die Rakeleinrichtung erfolgt, wobei trotz eines hohen Durchsatz von Substraten die Substrate nicht gruppenweise, sondern nacheinander aus der Druckvorrichtung ausgeführt werden, wodurch sich ein vorteilhafter Bearbeitungsfluss, insbesondere in einer Fertigungslinie, die sich an die Druckvorrichtung anschließt, ergibt.

Die erfindungsgemäße Druckvorrichtung zeichnet sich dadurch aus, dass der Drucktisch mehrere nebeneinanderliegend angeordnete Fördereinrichtungen aufweist, die jeweils zumindest ein Drucknest insbesondere auf dem Drucktisch aufweisen, und dass die Rakeleinrichtung zumindest ein Rakel aufweist, das über jedes Drucknest hinweg bewegbar ist, um die in oder auf den Drucknestern angeordneten Substrate nacheinander zu bedrucken. Durch die mehreren Fördereinrichtungen können die Substrate auf verschiedenen Wegen dem Drucktisch zugeführt und von dem Drucktisch abgeführt werden, sodass die Zuführung und Abführung der Substrate durch die Fördereinrichtungen unabhängig zueinander erfolgen kann. Die Anordnung der Fördereinrichtungen nebeneinander ist dabei in Bezug auf die Förderrichtung der Fördereinrichtungen zu verstehen. Durch diese Anordnung liegen die Fördereinrichtungen oder deren Förderbahnen in Bezug auf die Bewegungsrichtung der Rakeleinrichtung beziehungsweise des Rakels hintereinander. So kann beispielsweise ein Substrat zugeführt werden, während ein anderes Substrat bedruckt und ein drittes Substrat abgeführt wird. Die Fördereinrichtungen liegen nebeneinander, sodass die Förderrichtungen beziehungsweise die Förderlinien oder -wege parallel zueinander durch die Druckvorrichtung oder über den Drucktisch verlaufen. Dadurch, dass die Rakeleinrichtung ein Rakel aufweist, das über jedes Drucknest hinweg bewegbar ist, können die auf dem jeweiligen Drucknest abgelegten beziehungsweise angeordneten Substrate durch das eine Rakel nacheinander bedruckt werden. Das heißt, es ist nur eine Rakeleinrichtung beziehungsweise eine Rakeleinrichtung mit nur einem Rakel notwendig, um alle Drucknester des Drucktischs zu bedienen. Zweckmäßigerweise liegen die Drucknester dabei in einer Reihe hintereinander, die der Bewegungsrichtung, oder Hauptbewegungsrichtung des Rakels entsprechend folgt. Dadurch ist durch eine einfache Rakelbewegung ein Substrat nach dem anderen bedruckbar. Durch eine vorteilhafte Ansteuerung der Fördereinrichtung und Rakeleinrichtung kann somit ein gleichmäßiger Durchfluss von Substraten durch die Druckvorrichtung gewährleistet werden, der zu einer zeitlich gleichmäßigen Ausgabe von bedruckten Substraten führt. Dadurch wird einerseits ein hoher Substratdurchsatz durch die Druckvorrichtung gewährleistet, und andererseits eine gleichmäßige Substratausgabe.

Bevorzugt weist die Rakeleinrichtung zumindest ein Drucksieb auf, das einen Siebrahmen aufweist, der ein Sieb trägt. Unter einem Drucksieb ist im Zusammenhang mit der vorliegenden Erfindung auch eine Druckmaske zu verstehen. Druckmaske und Drucksieb haben jeweils für die Druckmasse durchlässige und nicht-durchlässige Bereiche (Druckmuster), insbesondere in dem Sieb, durch welche das gewünschte Druckbild auf dem jeweiligen Substrat während eines Rakelvorgangs erzeugt wird. Zweckmäßigerweise ist daher das Drucksieb oberhalb der Drucknester angeordnet.

Erfindungsgemäß ist jedem Drucknest zumindest eine Sensoreinrichtung zum Erfassen der Position eines auf dem jeweiligen Drucknest angeordneten Substrats zugeordnet oder zuordenbar, wobei dem Drucktisch und/oder der Rakeleinrichtung zumindest eine ansteuerbare Verstelleinrichtung zum Ausrichten von Drucksieb und Substrat zueinander zugeordnet ist. Durch die Verstelleinrichtung und die Sensoreinrichtung wird eine korrekte Ausrichtung von Substrat und Drucksieb zueinander gewährleistet. Zum Erfassen der Position und/oder Ausrichtung werden vorzugsweise Markierungen, sogenannte Fiducials auf den Substraten platziert, die eine Erfassung der Position und Ausrichtung der Substrate optisch ermöglichen. Mittels der zumindest einen Sensoreinrichtung ist somit die Position der jeweils auf den Drucknestern positionierten Substrate relativ zu dem Drucksieb erfassbar. Dazu ist die Sensoreinrichtung beispielsweise dazu ausgebildet, sowohl das untenliegende Substrat als auch das darüberliegende Drucksieb, vorzugsweise optisch, zu erfassen, um deren Position und Ausrichtung zueinander zu bestimmen. Durch das Ansteuern der Verstelleinrichtung ist das jeweilige Substrat passend zu dem Drucksieb positionierbar und ausrichtbar. Dazu ist die Verstelleinrichtung beispielsweise dazu ausgebildet, den Drucktisch insgesamt zu bewegen. Dabei werden zwar alle Drucknester und die darauf befindlichen Substrate mitbewegt, jedoch ist dies aufgrund des sequenziellen Rakelvorgangs, der von einem Drucknest zum Nächsten führt, in den Rakelpausen beziehungsweise in dem Moment, in welchem das Rakel von einem Drucknest zum nächsten Drucknest überführt wird, möglich, ohne dass dabei ein Rakelvorgang unterbrochen, ein Rakelergebnis beeinträchtigt oder das Fördern eines Substrats auf den Drucktisch oder von dem Drucktisch an einer anderen Fördereinrichtung des Drucktischs behindert wird. Ist die Verstelleinrichtung der Rakeleinrichtung zugeordnet, um diese zur Anpassung des Drucksiebs zu dem zu bedruckenden Substrat durchzuführen, ergeben sich die gleichen Vorteile. Optional ist zusätzlich dem jeweiligen Drucknest eine Verstelleinrichtung zugeordnet, um das jeweilige Drucknest und damit das jeweilige Substrat individuell und unabhängig von den übrigen Substraten zu dem Drucksieb zu positionieren.

Vorzugsweise weist die oder die jeweilige Verstelleinrichtung zumindest einen ansteuerbaren Aktuator zum Bewegen des Drucktisches und/oder des Drucksiebs auf. Der Aktuator ist insbesondere ein pneumatischer, hydraulischer, elektromotorischer, elektromechanischer oder elektromagnetischer Aktuator. Vorzugsweise weist die Verstelleinrichtung mehrere Aktuatoren auf, um eine Bewegung des Drucktischs und/oder des Drucksiebs in unterschiedliche Richtungen zu ermöglichen. Insbesondere ist die Verstelleinrichtung derart ausgebildet, dass sie das jeweilige Element, also Drucktisch und/oder Drucksieb, in einer Ebene in mindestens zwei unterschiedliche Richtungen verschieben und um eine insbesondere senkrecht zu der Ebene ausgerichtete Vertikalachse verdrehen kann. Optional ist die Verstelleinrichtung derart ausgebildet, dass sie auch ein Verkippen des jeweiligen Substrats beziehungsweise des Drucktischs und/oder das Drucksiebs ermöglicht. Gemäß einer besonders bevorzugten Ausführungsform der Erfindung ist die Verstelleinrichtung zumindest oder allein dem Drucksieb zugeordnet, um dieses insbesondere in Abhängigkeit von der Position und/oder Ausrichtung der zu bedruckenden Substrate auszurichten.

Gemäß einer bevorzugten Weiterbildung der Erfindung ist eine Steuereinrichtung vorhanden, die mit der Sensoreinrichtung und mit der zumindest einen Verstelleinrichtung zu deren Ansteuerung verbunden und speziell dazu hergerichtet ist, das jeweils zu bedruckende Substrat und das Drucksieb durch Ansteuern des zumindest einen Aktuators beziehungsweise der zumindest einen Verstelleinrichtung für einen Druckvorgang zueinander auszurichten. Es ergeben sich hierdurch die bereits genannten Vorteile.

Besonders bevorzugt weist die Sensoreinrichtung zumindest eine Kameraeinrichtung zum Erfassen eines Substrats auf einem Drucknest auf. Dadurch ist eine optische Erfassung eines Substrats und optional auch des Drucksiebs, gewährleistet. Das optische Erfassen der tatsächlichen Position und Ausrichtung zur Einstellung der korrekten Anordnung von Drucksieb und Substrat zueinander wird schon erfolgreich in anderen Druckvorrichtungen eingesetzt. Somit kann auf bekannte Technik zurückgegriffen werden. Vorteilhaft hier ist, dass die bekannte Erfassungstechnik in einer Druckvorrichtung eingesetzt wird, bei welcher mehrere Förderwege bestehen, die von nur einem Rakel bedient werden. Ist nur eine Kameraeinrichtung vorhanden, erfolgt eine sequenzielle Erfassung beziehungsweise eine Erfassung der Substrate nacheinander. Optional sind mehrere Kameraeinrichtung vorhanden, sodass eine zeitgleiche Erfassung, insbesondere der Substratposition an mehreren Drucknestern, möglich ist. Besonders bevorzugt ist jedem Drucknest wenigstens eine Kameraeinrichtung zugeordnet, um die Anordnung und Ausrichtung eines Substrats an dem jeweiligen Drucknest sicher zu erfassen.

Optional ist vorgesehen, dass die Sensoreinrichtung zumindest eine verfahrbare Kameraeinrichtung aufweist, welche zu jedem Drucknest bewegbar ist, um die Ausrichtung der Substrate in dem jeweiligen Drucknest nacheinander zu erfassen. Durch das Vorsehen einer verfahrbaren Kameraeinrichtung kann die Vielzahl der einzelnen Kameraeinrichtungen deutlich reduziert, insbesondere bis auf eine einzige Kameraeinrichtung reduziert werden, sodass die Herstellungskosten beziehungsweise die Anzahl der Einzelteile reduziert wird. Vorzugsweise ist Kameraeinrichtung dazu eine bewegliche Trägereinrichtung zugeordnet, wie beispielsweise ein die Kamera tragender Roboterarm oder ein Schienensystem, entlang dessen die Kameraeinrichtung verschiebbar ist, insbesondere Gantry-System.

Gemäß einer bevorzugten Weiterbildung der Erfindung weist die Sensoreinrichtung für jedes der Drucknester jeweils mindestens eine, insbesondere ortsfeste, Kameraeinrichtung auf. Insbesondere ist die jeweilige Kameraeinrichtung in das zugehörige Drucknest integriert angeordnet, sodass das Drucknest zusammen mit der Sensoreinrichtung eine Einheit bildet, die die Montage Druckvorrichtung erleichtert.

Vorzugsweise ist die Steuereinrichtung dazu hergerichtet, die Sensoreinrichtung derart anzusteuern, dass die Position und Ausrichtung eines Substrats auf einem Drucknest erfasst wird, bevor das Rakel dieses Drucknest erreicht. Insbesondere ist die Steuereinrichtung dazu hergerichtet, die Position eines Substrats auf einem Drucknest zu erfassen, während ein Substrat auf einem anderen, insbesondere auf einem benachbarten, Drucknest bedruckt wird. Vorzugsweise ist die Steuereinrichtung außerdem dazu hergerichtet, die dem Drucktisch oder dem Drucksieb zugeordnete Verstelleinrichtung nur nach oder vor einem Druckvorgang, also nicht während eines Druckvorgangs, sondern beispielsweise zwischen zwei aufeinanderfolgenden Druckvorgängen, anzusteuern. Dadurch ist gewährleistet, dass die Substrate nicht während eines Druckvorgangs in ihrer Position oder Ausrichtung verändert werden.

Vorzugsweise weist das jeweilige Drucknest eine Hubvorrichtung auf, mittels welcher das zu bedruckende Substrat in Richtung des Drucksiebs anhebbar ist. Durch die Hubvorrichtung lassen sich die Substrate individuell in Richtung des Drucksiebs anheben, um einen vorbestimmten Absprung beziehungsweise Abstand zwischen Drucksieb und zu bedruckender Substratoberfläche einzustellen. Durch das Zuordnen einer Hubvorrichtung zu jedem Drucknest wird gewährleistet, dass der Abstand des Drucktischs selbst zu dem Drucksieb während eines Druckvorgangs gleich bleibt, was insbesondere Vorteile in Bezug auf die Fördereinrichtungen bietet, die dann keine Höhenunterschiede ausgleichen müssen.

Weiterhin ist bevorzugt vorgesehen, dass die Kameraeinrichtung derart verfahrbar ausgebildet ist, dass sie zum Erfassen der Ausrichtung und/oder Position eines Substrats zwischen Drucktisch und Drucksieb einfahrbar und zum Erreichen einer Nichtgebrauchsposition neben den Drucktisch und das Drucksieb verfahrbar ist. Zur Erfassung fährt die Kameraeinrichtung also zwischen Drucksieb und Drucktisch, während sie insbesondere während eines Rakelvorgangs, neben Drucktisch und Drucksieb, also beabstandet zu den beiden und nicht in dem Zwischenraum liegend, angeordnet ist. Dadurch ist sichergestellt, dass die Kameraeinrichtung nicht versehentlich mit Druckmasse beaufschlagt wird, die sich gegebenenfalls von dem Drucksieb löst.

Vorzugsweise weist das jeweilige Drucknest Mittel zum Fixieren eines zu bedruckenden Substrats auf. Durch das Fixieren des zu bedruckenden Substrats ist sichergestellt, dass sich das Substrat während des Rakelvorgangs nicht verschiebt oder in seiner Ausrichtung verändert. Dadurch wird die Druckqualität dauerhaft aufrechterhalten. Die Fixiermittel weisen beispielsweise eine ansteuerbare Klemmvorrichtung auf, die mit dem Seitenrand eines Substrats zusammenwirkt, und/oder welche das Substrat auf einen Boden des Drucknests zur Fixierung presst, oder eine Vakuum- beziehungsweise Saugvorrichtung.

Gemäß einer bevorzugten Ausführungsform der Erfindung weist die Rakeleinrichtung ein einziges, sich über alle Drucknester erstreckendes Drucksieb auf, das für jedes Drucknest ein Druckmuster aufweist. In dem Drucksieb sind somit mehrere Druckmuster vorhanden, die gleich oder unterschiedlich ausgebildet sein können, wobei jedes Druckmuster einem der Drucknester zugeordnet ist. Dadurch kann das Rakel einfach über die Druckmuster hinwegbewegt werden, um nacheinander die Substrate in den Drucknestern zu bedrucken.

Gemäß einer alternativen - nicht erfindungsgemäßen - Ausführungsform ist vorgesehen, dass die Rakeleinrichtung für jedes Drucknest ein eigenes Drucksieb mit einem Druckmuster aufweist. Jedes Drucksieb weist standardmäßig einen Rahmen auf, der das eigentliche Sieb trägt oder hält. Der Rahmen dient zur Anordnung und Befestigung des Drucksiebs an der Rakeleinrichtung und ist beispielsweise derart ausgebildet, dass das Drucksieb auch austauschbar an der Rakeleinrichtung gehalten oder haltbar ist. Weist die Rakeleinrichtung für jedes der Drucknester ein Drucksieb auf, ergibt sich damit, dass zwischen benachbarten Druckmustern Rahmenabschnitte der Drucksiebe liegen, die in der Regel in der Höhe von dem jeweiligen Druckmuster vorstehen. Dadurch werden die benachbarten Druckmuster durch die Rahmenabschnitte voneinander getrennt, wodurch sichergestellt ist, dass Druckmasse, die auf eines der Drucksiebe aufgetragen wurde, nicht versehentlich auf das benachbarte Druckmuster gelangt. Dadurch ist eine vorteilhafte Trennung der benachbarten Druckmuster zueinander geschaffen. Auch ermöglicht es diese Ausführungsform, dass einzelne Drucksiebe ausgetauscht werden können, um einzelne Druckmuster auszutauschen beziehungsweise an gewünschte Druckbilder anzupassen, ohne dafür auch die anderen Druckmuster aus der Rakeleinrichtung zu entfernen. Dadurch kann beispielsweise ein Drucksieb entfernt werden, während ein Rakelvorgang an einem benachbarten oder einem weiteren Drucksieb der Rakeleinrichtung erfolgt. Insbesondere ist eine Einrichtung zum automatischen Einsetzen und Entnehmen eines oder mehrerer Drucksiebe der Rakeleinrichtung zugeordnet, um einen einfachen Austauschprozess von dem einen oder einem einzelnen der mehreren Drucksiebe zu ermöglichen.

Weiterhin ist bevorzugt vorgesehen, dass die Rakeleinrichtung eine Flutungseinrichtung aufweist, die dazu ausgebildet ist, die Rakeleinrichtung, insbesondere das Drucksieb der Rakeleinrichtung, mit dem Druckmedium beziehungsweise mit der Druckmasse zu fluten, bevor durch das Bewegen des Rakels ein Druckvorgang ausgeführt wird. Durch die Flutungseinrichtung wird somit das Druckmedium bereitgestellt, dass durch die Rakeleinrichtung auf die Substrate aufgedruckt werden soll. Dadurch, dass die Rakeleinrichtung mit dem Druckmedium vor dem Bewegen des Rakels geflutet wird, ist vorteilhaft sichergestellt, dass beim Bewegen des Rakels ein Druckvorgang ausgeführt wird. Vorzugsweise weist die Flutungseinrichtung ein Flutrakel auf, das dazu dient, das Druckmedium gleichmäßig auf dem Drucksieb oder der Druckschablone zu verteilen.

Das erfindungsgemäße Verfahren mit den Merkmalen des Anspruchs 12 zeichnet sich dadurch aus, dass die Substrate entlang mehrerer nebeneinanderliegend angeordneter Fördereinrichtungen jeweils einem von mehreren nebeneinanderliegend angeordneten - in Förderrichtung der Fördereinrichtungen gesehen - Drucknestern zugeführt, durch die Rakeleinrichtung nacheinander bedruckt und abgeführt werden. Dabei ist insbesondere vorgesehen, dass ein bedrucktes Substrat bereits abgeführt wird, bevor auch die übrigen Substrate durch die Rakeleinrichtung bedruckt wurden. Dadurch ergibt sich eine kontinuierliche Bearbeitung der Substrate, wodurch sich die oben genannte kontinuierliche Verarbeitung beziehungsweise Bereitstellung bedruckter Substrate ergibt. Insbesondere wird jedes bedruckte Substrat nach dem Druckvorgang und optional einer Härtungspause, aus dem jeweiligen Drucknest entnommen und durch die Fördereinrichtung weiter transportiert, unabhängig davon, ob an dem benachbarten Drucknest ein Rakelvorgang bereits ausgeführt wird oder wurde.

Vorzugsweise wird vor dem Bedrucken jedes Substrats dessen Anordnung und Ausrichtung mithilfe einer Sensoreinrichtung, wie obenstehend bereits beschrieben, erfasst und die Position und Ausrichtung des Substrats an die Position und Ausrichtung des Drucksiebs angepasst. Dazu werden insbesondere eine oder mehrere Verstelleinrichtungen angesteuert, die dem Drucktisch, und/oder dem Drucksieb zugeordnet sind. Insbesondere wird die Position und Ausrichtung der Substrate und/oder des Drucksiebs mithilfe zumindest einer Kameraeinrichtung erfasst, wie obenstehend bereits beschrieben. Vorzugsweise wird die Position auf einem Drucknest erfasst, bevor das Rakel dieses Drucknest zur Ausführung eines Druckvorgangs erreicht. Insbesondere wird die Position eines Substrats auf dem Drucknest zeitnah nach dessen Positionierung auf dem Drucknest erfasst, unabhängig davon, wie weit das Rakel von dem Drucknest zur Durchführung eines Druckvorgangs entfernt ist.

Besonders bevorzugt wird die Position eines Substrats auf einem Drucknest erfasst, während ein Substrat auf einem anderen, insbesondere auf einem benachbarten Drucknest, bedruckt wird. Es ergibt sich dadurch eine Gleichzeitigkeit von Verfahrensschritten, durch welche der Durchsatz der Druckvorrichtung weiter erhöht wird.

Besonders bevorzugt wird die eine oder die jeweilige Verstelleinrichtung nur zwischen zwei aufeinanderfolgenden Druckvorgängen oder Teildruckvorgängen angesteuert, also insbesondere in der Zeitspanne, in welcher das Rakel keinen Druckvorgang ausführt beziehungsweise in welcher das Rakel von einem Druckmuster zum nächsten Druckmuster transportiert wird. Dabei ist insbesondere vorgesehen, dass zuerst die Position und Ausrichtung aller Substrate erfasst wird, und dass die eine oder die mehreren Verstelleinrichtungen nur dann angesteuert werden, wenn das Rakel zwischen zwei Druckmustern oder vor dem ersten zu verwendenden Druckmuster liegt. Vorzugsweise wird immer nur das Substrat ausgerichtet, dessen zugeordnetes Druckmuster als nächstes durch das Rakel überstrichen wird. So wird beispielsweise die Verstelleinrichtung zur Ausrichtung des zweiten zu bedruckenden Substrats erst dann angesteuert, wenn das Rakel das dem ersten Substrat zugeordnete Druckmuster bereits vollständig überstrichen und das folgende Druckmuster noch nicht erreicht hat. Zum Durchführen eines Rakelvorgangs wird bevorzugt außerdem das jeweilige Drucknest durch eine Hubvorrichtung angehoben, das Drucksieb in Richtung des Substrats abgesenkt und/oder der Drucktisch in Richtung des Drucksiebs angehoben, insbesondere um einen vorbestimmten Absprung einzustellen.

Gemäß einer bevorzugten Ausführungsform der Erfindung werden zunächst die Substrate nacheinander mittels der Rakeleinrichtung bedruckt, indem die Rakeleinrichtung, insbesondere das Drucksieb, zunächst mit einem Druckmedium geflutet und anschließend das Rakel zur Durchführung eines Druckvorgangs von einer Ausgangsposition in eine Richtung über alle Drucknester nacheinander hinwegbewegt wird. Dadurch werden in kurzer Zeit die auf den Drucknestern angeordneten Substrate bedruckt. Durch die vorteilhafte Erfassung der Position und Ausrichtung der Substrate mittels der Verstelleinrichtung oder -einrichtungen ist ein präzises Bedrucken aller Substrate gewährleistet.

Vorzugsweise wird das Rakel anschließend über alle Drucknester hinweg in die Ausgangsposition zurück bewegt. Die Rakeleinrichtung wird somit wieder in ihren Ausgangszustand zurückgeführt und ein weiterer Druckvorgang kann erfolgen.

Optional ist bevorzugt vorgesehen, dass bei der Zurückbewegung der Rakeleinrichtung das Drucksieb, insbesondere das Siebgewebe, oder eine Druckschablone erneut mit Druckmedium und insbesondere mit Hilfe eines Flutrakels, das für den Rückweg der Rakeleinrichtung eingesetzt wird, geflutet wird, so dass direkt im Anschluss ein weiterer Druckvorgang ohne Stillstand des Rakelwerks, abgesehen von einem gegebenenfalls kurzen Stillstand beim Richtungswechsel, ausgeführt werden kann. Dadurch wird sowohl bei der Hin- als auch bei der Zurückbewegung des Rakels jeweils ein Druckvorgang über alle Drucknester ausgeführt. Hierdurch wird der Durchsatz der Druckvorrichtung erhöht. Insbesondere wird die Druckvorrichtung derart angesteuert, dass bei dem Zurückbewegen die bereits einmal bedruckten Substrate ein zweites Mal bedruckt werden, beispielsweise um die Druckhöhe auf dem jeweiligen Substrat zu vergrößern. Hierzu werden die Fördereinrichtung vor dem Zurückbewegen nicht angesteuert, so dass die Substrate auf den Drucknestern verbleiben.

Alternativ werden die Fördereinrichtungen bevorzugt dazu angesteuert, jeweils ein bedrucktes Substrat aus dem Drucknest weg zu transportieren und ein zu bedruckendes Substrat auf das Drucknest zu transportieren bevor das Rakel zurückbewegt wird. Dadurch werden beim Zurückbewegen des Rakels neue Substrate durch die Druckvorrichtung bedruckt, wodurch der Durchsatz der Druckvorrichtung ebenfalls erhöht wird. Wobei auch vor dem Zurückbewegen des Rakels, die Substrate und das Drucksieb, wie zu vor beschrieben, zueinander ausgerichtet werden.

Weitere Vorteile und bevorzugte Merkmale und Merkmalskombinationen ergeben sich insbesondere aus dem zuvor Beschriebenen sowie aus den Ansprüchen. Im Folgenden soll die Erfindung anhand der Zeichnung näher erläutert werden. Dazu zeigen
- Figur 1: eine vorteilhafte Druckvorrichtung in einer vereinfachten perspektiven Darstellung,
- Figur 2: die Druckvorrichtung in einer vereinfachten Draufsicht,
- Figur 3: die Druckvorrichtung in einer vereinfachten Seitenansicht, und
- Figur 4: die vorteilhafte Druckvorrichtung gemäß einem weiteren Ausführungsbeispiel in einer vorteilhaften Draufsicht.

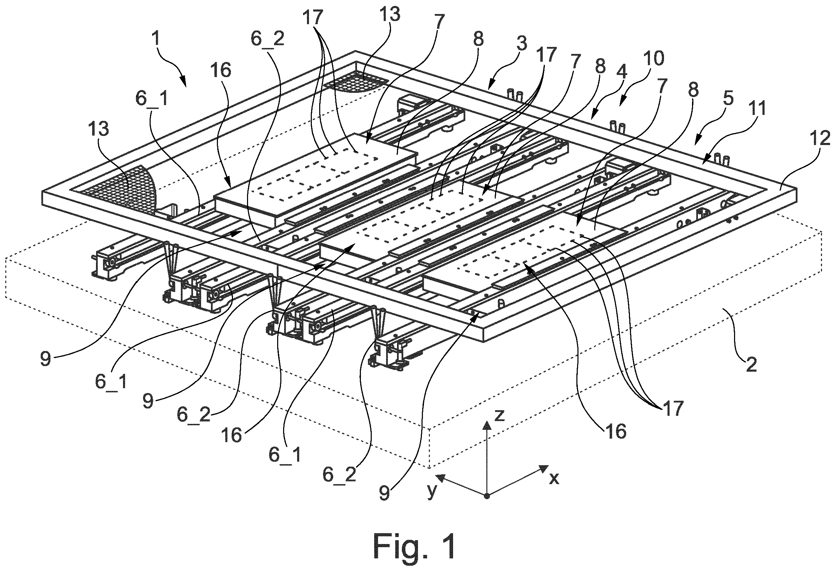

Figur 1 zeigt in einer perspektivischen Darstellung eine vorteilhafte Druckvorrichtung 1 zum Bedrucken von flachen beziehungsweise flächigen Substraten, wie beispielsweise Wafer, Leiterplatten oder Solarzellen. Die Druckvorrichtung 1 weist vorliegend einen Drucktisch 2 auf, auf welchem mehrere, vorliegend drei, Fördereinrichtungen 3, 4, 5 nebeneinander und parallel zueinander ausgerichtet angeordnet sind. Jede Fördereinrichtung 3, 4, 5 weist zwei parallel zueinander und beabstandet voneinander angeordnete Förderbänder 6_1 und 6_2 auf. Der Abstand der Förderbänder 6_1, 6_2 ist dabei derart gewählt, dass ein zu bedruckendes Substrat an seinen Seitenrändern auf den Förderbändern aufliegen kann. Durch Antreiben der Förderbänder können die darauf gelegenen Substrate entlang der jeweiligen Fördereinrichtung 3, 4, 5 über den Drucktisch transportiert werden. Etwa in der Mitte der Längserstreckung der jeweiligen Fördereinrichtungen 3, 4, 5 ist ein Drucknest 7 angeordnet, an welchem das Substrat fixierbar ist.

Gemäß dem vorliegenden Ausführungsbeispiel weist das jeweilige Drucknest 7 eine Substratsauflage 8 auf, die zwischen den beiden Förderbändern 6_1, 6_2 liegt. Die Substratauflage 8 ist insbesondere jeweils als eine ebene Platte ausgebildet, auf welcher das jeweilige Substrat ablegbar ist.

Vorzugsweise ist die jeweilige Substratauflage 8 durch eine Hubvorrichtung 9 in der Höhe derart verlagerbar, dass sie in einer Ausgangsstellung auf Höhe des Transportbands 6_1, 6_2 oder knapp darunter liegt, und in einer weiteren Stellung das zu bedruckende Substrat von den Transportbändern 6_1, 6_2 anhebt, sodass es von der Transporteinrichtung 3, 4, 5 gelöst ist. In Figur 1 ist dies beispielhaft derart gezeigt, dass die Substratauflage 8 der Fördereinrichtung 3 angehoben ist, während die Substratauflagen 8 der Transporteinrichtungen 4, 5 sich in ihrer Grundstellung befinden, in welcher ein Substrat durch die jeweilige Fördereinrichtung auf die Substratauflage 8 schiebbar ist.

Oberhalb des Drucktischs 2 und damit beabstandet zu den Fördereinrichtungen 3, 4, 5 ist eine Rakeleinrichtung 10 angeordnet, von der in Figur 1 lediglich ein Drucksieb 11 gezeigt ist. Das Drucksieb 11 weist einen Siebrahmen 12 auf, welcher ein Siebgewebe oder Sieb 13 trägt (in Figur 1 aus Übersichtlichkeitsgründen nur bereichsweise gezeigt). Das Sieb 13 füllt jedoch den gesamten Siebrahmen 12 aus.

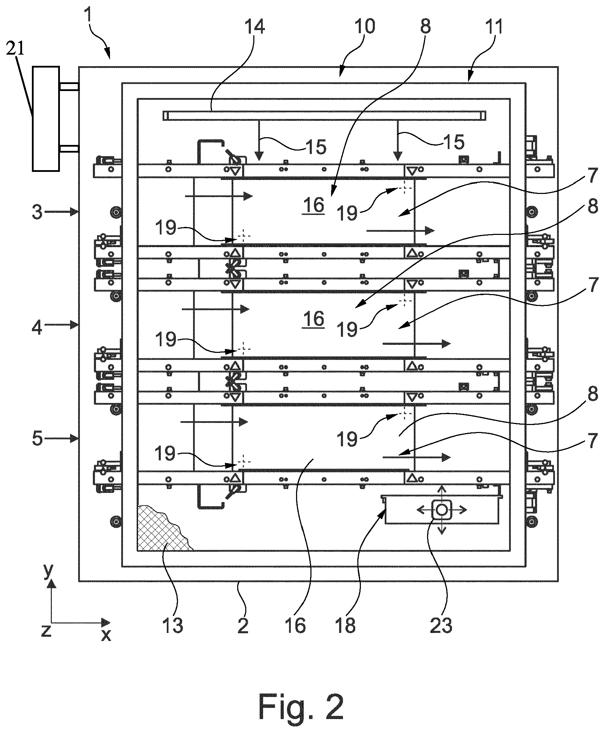

Figur 2 zeigt eine vereinfachte Draufsicht auf die Druckvorrichtung 1 aus Figur 1. Bereits genannte Elemente werden in den folgenden Figuren mit den gleichen Bezugszeichen versehen.

Gemäß dem vorliegenden Ausgangsbeispiels ragen die Transporteinrichtungen 3, 4, 5 einseitig über den Siebrahmen 12 hinaus. Gemäß einem weiteren, hier nicht dargestellten Ausführungsbeispiel, liegen die Transporteinrichtungen 3, 4, 5 vollständig innerhalb des Rahmens 12. Größe und Länge des Siebrahmens 12 in Bezug auf die Fördereinrichtung 3, 4, 5 ist jedoch weniger relevant. Wichtig ist, dass der Siebrahmen 12 zumindest den Bereich umspannt, in welchem sich die Drucknester 7 der Fördereinrichtungen 3, 4, 5 befinden.

Die Rakeleinrichtung 10 weist weiterhin ein verlagerbares Rakel 14 auf, das an seinem freien, dem Drucksieb 11 zugewandten Ende insbesondere zumindest eine Rakelklinge aufweist, die über das Sieb 13 gestrichen werden kann. Die Bewegungsrichtung des Rakels ist dabei in Figur 2 durch Pfeile 15 angezeigt. Das Rakel 14 ist derart bewegbar, dass es über die Drucknester 7 der Fördereinrichtungen 3, 4, 5 nacheinander führbar ist, sodass an den Drucknestern 7 fixierte Substrate nacheinander bedruckt werden. In Figur 2 sind dazu beispielhaft drei Substrate 16 gezeigt, wobei auf jedem der Drucknester 7 jeweils eines der Substrate 16 angeordnet und fixiert ist.

Jedes Drucknest 7 weist eine eigene Fixiereinrichtung auf. Gemäß dem Ausführungsbeispiel von Figur 1 ist die jeweilige Fixiereinrichtung als Vakuumeinrichtung ausgebildet, die mehrere in der Substratauflage 8 ausgebildete Saugöffnungen 17 aufweist, welche mit einer Saugpumpe oder Saugeinrichtung verbunden sind. Optional sind die Saugöffnungen 17 mit einem gemeinsamen Saugkanal verbunden, der zu der Saugpumpe führt. Insbesondere ist in dem gemeinsamen Saugkanal zumindest ein ansteuerbares Ventil angeordnet, um die Saugwirkung beziehungsweise Sogwirkung der Saugöffnungen 17 eines Drucknests 7 bei Bedarf ein- und abzuschalten. Dadurch kann ein auf der Substratablage 8 abgelegtes Substrat durch den mittels der Saugpumpe erzeugten Unterdruck an der Substratauflage 8 fixiert werden. Hierdurch ist gewährleistet, dass das einmal angeordnete Substrat nicht während eines Rakelvorgangs verschoben oder verdreht wird.

Für jedes Drucknest 7 weist das Sieb 13 ein separates Druckmuster auf. Das bedeutet, dass die Druckmuster für alle Drucknester 7 gleich ausgebildet oder unterschiedlich ausgebildet sein können.

Die Druckvorrichtung 1 weist weiterhin eine Sensorvorrichtung 18 auf, die dazu dient, die Anordnung eines Substrats auf einem Drucknest 7 zu erfassen. Vorteilhafterweise werden oder sind die Substrate 16 mit optischen Markierungen (Fiducials) versehen, wie in Figur 2 beispielhaft gezeigt. Die Markierungen 19 sind dort beispielhaft in Form von Kreuzen auf der von der Substratauflage 8 abgewandten Oberseite des jeweiligen Substrats 16 aufgezeichnet. Die Markierungen können farbige Markierungen oder durch ein Relief in der Oberfläche des Substrats 16 gestaltet sein.

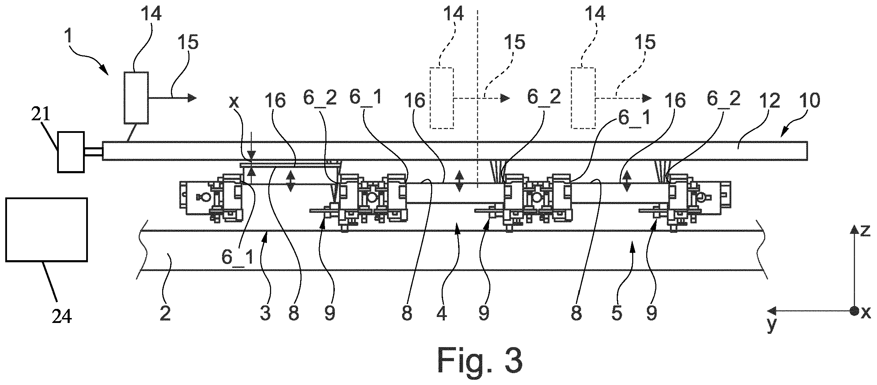

**Figur 3** zeigt die Druckvorrichtung 1 in einer vereinfachten Seitenansicht, in welcher insbesondere die angehoben Substratsauflage 8 der Fördereinrichtung 3 zu erkennen ist. Durch das Anheben des Substrats wird außerdem ein vorbestimmter Abstand x zwischen Drucksieb 11 und Substrat 16 eingestellt, der den sogenannten Absprung zwischen Sieb und der zu bedruckenden Oberfläche des Substrats 16 definiert. Der Absprung wird derart gewählt, dass sich ein optimales Druckbild auf dem Substrat 16 ergibt. Weil das Rakel 14 mit einer oder mehreren Rakelklingen quer zur Förderrichtung der Fördereinrichtungen 3, 4, 5 über die Fördereinrichtungen 3, 4, 5 beziehungsweise die Drucknester 7 hinwegbewegt wird, ist stets das Substrat 16 angehoben, das als nächstes zu bedrucken ist.

Die Druckvorrichtung 1 weist weiterhin zumindest eine Verstelleinrichtung 21 auf, wie beispielhaft in Figur 2 gezeigt, die gemäß dem vorliegenden Ausführungsbeispiel dem Drucktisch 2 zugeordnet und dazu ausgebildet ist, den Drucktisch 2 in der Drucktischebene in zumindest zwei Richtungen (x- und y-Richtung) zu verschieben und insbesondere um eine senkrecht zu der Drucktischebene 2 ausgerichtete Vertikalachse z zu verschwenken.

Die Funktionsweise der Druckvorrichtung ist gemäß einem Ausführungsbeispiel die Folgende:
Mittels der Fördereinrichtungen 3, 4, 5 werden zu bedruckende Substrate 16 in Richtung der Drucknester 7 gefördert und an dem jeweiligen Drucknest 7 fixiert. Dabei können die Substrate parallel oder nacheinander durch die Fördereinrichtungen 3, 4, 5 den Drucknestern 7 zugeführt werden. Mittels der Sensoreinrichtung 18 wird das zuerst zugeführte Substrat 16 oder das in der vordersten Förderbahn beziehungsweise Fördereinrichtung 3 liegende Substrat 16 erfasst und seine Ausrichtung und Position zu dem zugeordneten Druckmuster des Drucksiebs 11 erfasst. Dazu weist die Sensoreinrichtung 18 bevorzugt eine Kameraeinrichtung 23 auf, die derart verfahrbar ausgebildet ist, dass sie zwischen Drucksieb 11 und Drucktisch 2 beziehungsweise Fördereinrichtungen 3, 4, 5 fahrbar ist, sodass mittels der Kameraeinrichtung 23 die Markierungen 19 der Substrate 16 erfasst werden können. Insbesondere ist die Kameraeinrichtung 23 auch dazu ausgebildet, die Position des Drucksiebs 11 zu erfassen. Die Kameraeinrichtung 23 ist beispielsweise durch ein Gantry-System oder -Antrieb an dem Drucktisch 2 angeordnet, sodass die Kameraeinrichtung 23 frei verfahrbar ist, um alle Markierungen 19 zu erfassen. In einem Nicht-Gebrauchszustand ist die Kameraeinrichtung 23 neben Drucktisch und Drucksieb verfahrbar, sodass sie außerhalb der Druckvorrichtung oder zumindest im Wesentlichen außerhalb der Druckvorrichtung 1 geschützt liegt.

Eine Steuereinrichtung 24 ist vorhanden, die zumindest mit der Sensoreinrichtung 18 und mit der Verstelleinrichtung 21 verbunden ist, um die erfasste Position und Ausrichtung der Substrate 16 auszuwerten beziehungsweise um Korrekturwerte zu ermitteln, die zum Erreichen einer vorbestimmten Position relativ zu dem Drucksieb 11 zum Erreichen der vorbestimmten Position notwendig sind. In Abhängigkeit der ermittelten Korrekturwerte steuert die Steuereinrichtung 24 die Verstelleinrichtung 21 dazu an, den Drucktisch 2 derart zu bewegen, dass das zuerst zu bedruckende Substrat 16 korrekt zu dem ihm zugeordneten Druckmuster des Drucksiebs 11 ausgerichtet ist. Erst anschließend wird die Rakeleinrichtung 14 durch die Steuereinrichtung 24 dazu angesteuert, den Druckvorgang an dem ersten Substrat 16 an der Fördereinrichtung 3 auszuführen.

Im nächsten Schritt wird durch die Steuereinrichtung 24 erneut die Sensorvorrichtung 18 dazu angesteuert, die Position und Ausrichtung des nächsten zu bedruckenden Substrats 16, in diesem Fall das Substrat 16 der Fördereinrichtung 4, relativ zu dem Drucksieb 11 zu erfassen und Korrekturwerte zu bestimmen. Nach erfassen oder ermittelen der Korrekturwerte wird erneut die Verstelleinrichtung 21 dazu angesteuert, den Drucktisch 2 derart zu bewegen, dass das Substrat 16 der Fördereinrichtung 4 korrekt zu dem Drucksieb 11 für den vorstehenden Druckvorgang ausgerichtet ist. Erst anschließend wird das Rakel 14 weiter zu der Fördereinrichtung 4 bewegt, um das dort in dem Drucknest 7 befindliche Substrat 16 zu bedrucken. Entsprechend wird bei dem Bedrucken des Substrats 16 im Drucknest 7 der Fördereinrichtung 5 vorgegangen. Anschließend werden die Substrate 16 mittels der Fördereinrichtungen 3, 4, 5 von dem Drucktisch 2 entfernt und es werden neue Substrate 16 den Drucknestern 7 zugeführt.

Vorzugsweise ist die Steuereinrichtung 24 derart ausgebildet, dass ein bedrucktes Substrat von dem Drucktisch 2 entfernt wird, sobald es bedruckt wurde. Dadurch können Substrate zur gleichen Zeit bedruckt, zugeführt und entfernt werden.

Vorzugsweise wird die Ausrichtung und Position der auf den Drucknestern 7 positionierten Substrate 16 vor Beginn des ersten Druckvorgangs mittels der Sensoreinrichtung 18 erfasst und dann bevorzugt das Drucksieb 11 zum Anpassen an die Position und Ausrichtung des jeweiligen Substrats vor dem jeweiligen Druckvorgang oder Druckteilvorgang verstellt. Hierbei werden Ausrichtung und Position aller zu bedruckender Substrate in oder auf den Drucknestern erfasst, bevor das Rakel zum Durchführen eines Druckvorgangs über das Drucksieb 11 hinweg bewegt wird. Die Ausrichtung beziehungsweise Korrektur der Ausrichtung mittels der Verstelleinrichtung 21 erfolgt vorzugsweise nur vor oder nach einem Druckvorgang, beispielsweise in den Druckpausen zwischen zwei aufeinanderfolgenden Druckvorgängen.

Alternativ zu der verfahrbaren Kameraeinrichtung 23 ist gemäß dem weiteren Ausführungsbeispiel vorgesehen, dass jedem Drucknest 7 wenigstens eine Kameraeinrichtung zugeordnet ist.

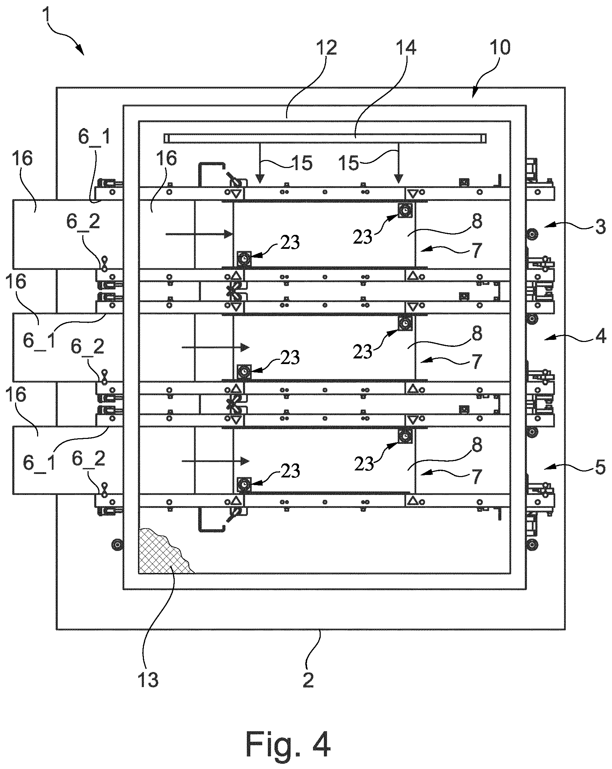

Figur 4 zeigt dazu eine weitere Draufsicht auf die Druckvorrichtung 1 gemäß dem weiteren Ausführungsbeispiel. Im Unterschied zu dem vorhergehenden Ausführungsbeispiel sind mehrere Kameraeinrichtungen 23 jedem Drucknest 7 zugeordnet. Dabei entspricht die Anzahl der Kameraeinrichtungen 23 insbesondere der Anzahl der Markierungen 19 auf dem jeweils zu erfassenden Substrat 16. Dabei sind die Kameraeinrichtungen 23 fix beziehungsweise fest an dem jeweiligen Drucknest 7 montiert, sodass auf eine Mechanik oder Antriebstechnik zum Verfahren der Kameraeinrichtung 23 verzichtet wird. Durch die mehreren Kameraeinrichtungen 23 ist in vorteilhafter Weise ein zeitnahes Erfassen der Position und Ausrichtung des jeweiligen Substrats 16 gewährleistet. Insbesondere können auch Position und Ausrichtung mehrere Substrate 16 gleichzeitig erfasst werden.

Gemäß einem weiteren Ausführungsbeispiel ist vorgesehen, dass nicht das jeweilige Drucknest 7 mit einer Hubvorrichtung ausgestattet ist, sondern dass stattdessen der gesamte Drucktischs 2 in z-Richtung angehoben und/oder das Drucksieb 11 in z-Richtung abgesenkt wird, um den gewünschten Absprung zwischen dem zu bedruckenden Substrat und dem Drucksieb 12 einzustellen.

Alternativ oder zusätzlich ist die Verstelleinrichtung 21 dem Drucksieb 11 zugeordnet, wie in Figur 3 beispielhaft gezeigt, so dass durch diese das Drucksieb 11 in der x-y-Ebene verschoben oder in z-Richtung angehoben und abgesenkt, und/oder um eine Achse insbesondere parallel zur z-Richtung verschwenkt werden kann, um die Zuordnung beziehungsweise Positionierung des jeweiligen Druckmusters zu dem jeweils zu bedruckenden Substrat 16 präzise einzustellen.

Das Korrigieren der Ausrichtung und Position des jeweiligen Substrats 16, das zu bedrucken ist, erfolgt in dem Zeitraum, in welchem das Rakel von dem zuvor bedruckten Substrat bis zu dem zu bedruckenden Substrat bewegt wird. Dadurch wird keine Zeit verloren und es wird ein hoher Durchfluss durch die Druckvorrichtung 1 gewährleistet. Besonders bevorzugt ist die Rakelgeschwindigkeit derart gewählt, dass das Rakel ohne Unterbrechung von einem Ende des Drucksiebs bis zum anderen Endes des Drucksiebs über alle Drucknester 7 hinweg gezogen werden kann, wobei dann die Verstellvorgänge zur Korrektur der Ausrichtung und Position des jeweils zu bedruckenden Substrats in dem Moment erfolgen, in welchem das Rakel über einem Bereich des Drucksiebs 11 gezogen wird, der für die Druckmasse undurchlässig ist. Ein solcher Bereich ist vorzugsweise jeweils zwischen den benachbarten Druckmustern des Drucksiebs 11 ausgebildet. Reicht die Zeit zum Korrigieren der Ausrichtung und/oder Position des jeweiligen Substrats 16 nicht aus, so wird der Rakelvorgang bevorzugt solange unterbrochen, bis das betroffene Substrat 16 korrekt ausgerichtet ist. Während gemäß dem vorliegenden Ausführungsbeispiel lediglich drei Fördereinrichtungen und damit nur drei Förderwege vorhanden sind, kann die Anzahl der Fördereinrichtungen beliebig erhöht werden, sodass auch Druckvorrichtungen mit 4, 5, 6 oder mehr Fördereinrichtungen und einer entsprechenden Anzahl von Förderwegen denkbar ist.

Alternativ zu der Vakuumeinrichtung 17 können auch mechanische Fixiermittel, wie beispielsweise Klemmmittel eingesetzt werden.

Vorzugsweise weist die Rakeleinrichtung eine Flutungseinrichtung auf, mittels welcher das Druckmedium auf das Drucksieb 11 aufbringbar ist. Vor Durchführung eines Druckvorgangs wird mittels der Flutungseinrichtung das Drucksieb 11 mit dem Druckmedium geflutet, sodass ausreichend Druckmedium auf dem Drucksieb 11 vorhanden ist, das durch das Rakel 14 durch das Sieb 13 hindurch auf die zu bedruckenden Substrate 16 in einem Druckvorgang aufbringbar ist.

Gemäß einem Ausführungsbeispiel werden die Substrate 16 nach einem erfolgten Druckvorgang über alle Drucknester 7 hinweg aus den Drucknestern 7 weg transportiert und es werden neue zu bedruckende Substrate auf den Drucknestern 7 platziert.

Gemäß einem weiteren Ausführungsbeispiel werden die Substrate 16 nach einem erfolgten Druckvorgang über alle Drucknester 7 hinweg in den Drucknestern belassen und das Rakel 14 erneut, diesmal jedoch in entgegengesetzter Richtung über die Drucknester hinweg bewegt, um einen weiteren Druckvorgang auszuführen.

Gemäß noch einem weiteren Ausführungsbeispiel, werden die Substrate vor dem Zurückbewegen des Rakels 14 in seine Ausgangsposition durch die Fördereinrichtungen 3,4,5 durch neue zu bedruckende Substrate ausgetauscht, so dass beim Zurückbewegen des Rakels 14, insbesondere nachdem das Drucksieb 11 erneut geflutet wurde, wie zuvor beschrieben, nunmehr die neuen Substrate 16 bedruckt werden. Hierdurch wird der Durchsatz der Druckvorrichtung 1 deutlich erhöht.

## Patentansprüche

1. Druckvorrichtung (1) zum Bedrucken von Substraten (16), insbesondere Solarzellen, Wafer oder Leiterplatten, mit einer Rakeleinrichtung (10) und mit zumindest einem Drucktisch (2), wobei die Rakeleinrichtung (10) oberhalb des Drucktischs (2) angeordnet ist, und mit zumindest einer Fördereinrichtung (3,4,5), mittels welcher jeweils ein Substrat (16) auf ein Drucknest (7) unterhalb der Rakeleinrichtung (10) und nach erfolgtem Druckvorgang aus dem Drucknest (7) weg transportierbar ist, wobei der Drucktisch (2) mehrere nebeneinanderliegend und parallel zueinander ausgerichtete Fördereinrichtungen (3,4,5) aufweist, die jeweils zumindest ein Drucknest (7) aufweisen, wobei die Rakeleinrichtung (10) ein einziges, sich über alle Drucknester (7) erstreckendes Drucksieb (11) aufweist, das für jedes Drucknest (7) ein Druckmuster aufweist, und wobei die Rakeleinrichtung (10) zumindest ein Rakel (14) aufweist, das über jedes Drucknest (7) hinweg bewegbar ist, um die in den Drucknestern (7) angeordneten Substrate (16) nacheinander zu bedrucken, wobei jedem Drucknest (7) zumindest eine Sensoreinrichtung (18) zum Erfassen der Position und/oder Ausrichtung eines auf dem jeweiligen Drucknest (7) angeordneten Substrats (16) zugeordnet oder zuordenbar ist, wobei dem Drucktisch (2) und/oder der Rakeleinrichtung (10) zumindest eine ansteuerbare Verstelleinrichtung (21) zum Ausrichten und/oder Positionieren des jeweiligen Substrats (16) und des Drucksiebs (11) zueinander zugeordnet ist, und wobei ein Korrigieren der Ausrichtung und/oder Position des jeweiligen Substrats (16) und des Drucksiebs (11) zueinander in dem Zeitraum erfolgt, in welchem das Rakel (14) von einem zuvor bedruckten Substrat (16) bis zu einem zu bedruckenden Substrat (16) bewegt wird.

2. Druckvorrichtung nach Anspruch 1, **dadurch gekennzeichnet, dass** die Rakeleinrichtung zumindest ein Drucksieb (11) aufweist, das einen Siebrahmen (12) aufweist, der ein Sieb (13) trägt.

3. Druckvorrichtung nach einem der vorhergehenden Ansprüche, **dadurch gekennzeichnet, dass** die Verstelleinrichtung (21) zumindest einen ansteuerbaren Aktuator zum Bewegen des Drucktischs (2) und/oder des Drucksiebs (11) aufweist.

4. Druckvorrichtung nach einem der vorhergehenden Ansprüche, **dadurch gekennzeichnet, dass** eine Steuereinrichtung (24) mit der Sensoreinrichtung (18) und mit der zumindest einen Verstelleinrichtung (21) verbunden und speziell dazu hergerichtet ist, Substrat (16) und Drucksieb (11) durch Ansteuern des zumindest einen Aktuators zueinander auszurichten.

5. Druckvorrichtung nach einem der vorhergehenden Ansprüche, **dadurch gekennzeichnet, dass** die Sensoreinrichtung (18) zumindest eine Kameraeinrichtung (23) zum Erfassen der Position und/oder Ausrichtung eines Substrats (16) auf zumindest einem der Drucknester (7) aufweist.

6. Druckvorrichtung nach einem der vorhergehenden Ansprüche, **dadurch gekennzeichnet, dass** die Sensoreinrichtung (18) eine verfahrbare Kameraeinrichtung (23) aufweist, welche zu jedem Drucknest (7) bewegbar ist, um die Ausrichtung und Position der Substrate (16) aller Drucknester (7) nacheinander zu erfassen.

7. Druckvorrichtung nach einem der vorhergehenden Ansprüche, **dadurch gekennzeichnet, dass** die Sensoreinrichtung (18) für jedes der Drucknester (7) jeweils mindestens eine, insbesondere mehrere, ortsfeste Kameraeinrichtungen (23) aufweisen.

8. Druckvorrichtung nach einem der vorhergehenden Ansprüche, **dadurch gekennzeichnet, dass** das jeweilige Drucknest (7) eine Hubvorrichtung (9) aufweist, mittels welcher das zu bedruckende Substrat (16) in Richtung des Drucksiebs (11) anhebbar ist.

9. Druckvorrichtung nach einem der vorhergehenden Ansprüche, **dadurch gekennzeichnet, dass** die Kameraeinrichtung (23) derart verfahrbar ausgebildet ist, dass sie zum Erfassen der Ausrichtung und/oder Position eines Substrats (16) zwischen Drucktisch (2) und Drucksieb (11) einfahrbar und zum Erreichen einer Nicht-Gebrauchsposition neben Drucktisch (2) und Drucksieb (11) verfahrbar ist.

10. Druckvorrichtung nach einem der vorhergehenden Ansprüche, **dadurch gekennzeichnet, dass** das jeweilige Drucknest (7) Fixiermittel zum Arretieren eines zu bedruckenden Substrats auf dem jeweiligen Drucknest (7) aufweist.

11. Druckvorrichtung nach einem der vorhergehenden Ansprüche, **dadurch gekennzeichnet, dass** die Rakeleinrichtung (10) eine Flutungseinrichtung aufweist, die dazu ausgebildet ist, die Rakeleinrichtung (10), insbesondere das Drucksieb (11) mit einem Druckmedium zu fluten, bevor durch das Bewegen des Rakels (14) ein Druckvorgang ausgeführt wird.

12. Verfahren zum Betreiben einer Druckvorrichtung, insbesondere gemäß einem der Ansprüche 1 bis 11, zum Bedrucken von Substraten, insbesondere Solarzellen, Wafer oder Leiterplatten, mit einer Rakeleinrichtung (10) und mit zumindest einem Drucktisch (2), wobei die Rakeleinrichtung (10) oberhalb des Drucktischs (2) angeordnet ist, und wobei ein zu bedruckendes Substrat (16) auf ein Drucknest (7) gefördert, bedruckt und anschließend von dem Drucknest (7) weg transportiert wird, wobei die Substrate (16) entlang mehrerer nebeneinanderliegend angeordneter Fördereinrichtungen (3,4,5) jeweils einem von mehreren nebeneinanderliegend angeordneten Drucknestern (7) zugeführt, durch ein Rakel (14) der Rakeleinrichtung (10) nacheinander bedruckt und abgeführt werden, wobei die Rakeleinrichtung (10) ein einziges, sich über alle Drucknester (7) erstreckendes Drucksieb (11) aufweist, das für jedes Drucknest (7) ein Druckmuster aufweist, und wobei jedem Drucknest (7) zumindest eine Sensoreinrichtung (18) zum Erfassen der Position und/oder Ausrichtung eines auf dem jeweiligen Drucknest (7) angeordneten Substrats (16) zugeordnet oder zuordenbar ist, wobei dem Drucktisch (2) und/oder der Rakeleinrichtung (10) zumindest eine ansteuerbare Verstelleinrichtung (21) zum Ausrichten und/oder Positionieren des jeweiligen Substrats (16) und des Drucksiebs (11) zueinander zugeordnet ist, und wobei eine Ausrichtung und/oder Position des jeweiligen Substrats (16) und des Drucksiebs (11) zueinander durch die Verstelleinrichtung (21) in dem Zeitraum korrigiert wird, in welchem das Rakel (14) von einem zuvor bedruckten Substrat (16) bis zu einem zu bedruckenden Substrat (16) bewegt wird.

13. Verfahren nach Anspruch 12, **dadurch gekennzeichnet, dass** zunächst die Substrate nacheinander mittels der Rakeleinrichtung (10) bedruckt werden, indem die Rakeleinrichtung (10) zunächst mit einem Druckmedium geflutet und anschließend das Rakel (14) zur Durchführung eines Druckvorgangs von einer Ausgangsposition in eine Richtung über alle Drucknester (7) nacheinander hinwegbewegt wird.

14. Verfahren nach Anspruch 13, **dadurch gekennzeichnet, dass** Rakel (14) anschließend über alle Drucknester (7) in die Ausgangsposition zurückbewegt wird.

15. Verfahren nach Anspruch 14, **dadurch gekennzeichnet, dass** bevor das Rakel (14) zurückbewegt wird, die Rakeleinrichtung (10) erneut mit Druckmedium geflutet wird, so dass das Rakel (14) beim Zurückbewegen einen weiteren Druckvorgang ausführt.

16. Verfahren nach Anspruch 15, **dadurch gekennzeichnet, dass** die Fördereinrichtungen (3,4,5) dazu angesteuert werden, jeweils ein bedrucktes Substrat (16) aus dem Drucknest weg zu transportieren und ein zu bedruckendes Substrat (16) auf das Drucknest (7) zu transportieren bevor das Rakel zurückbewegt wird.

## Claims

1. A printing device (1) for printing onto substrates (16), in particular solar cells, wafers or printed circuit boards, comprising a squeegee means (10) and comprising at least one printing table (2), wherein the squeegee means (10) is arranged above the printing table (2), and comprising at least one conveying means (3,4,5), by means of which a substrate (16) can be transported away in each case to a printing nest (7) below the squeegee means (10) and out of the printing nest (7) after the printing process has taken place, wherein the printing table (2) has several conveying means (3,4,5), which are arranged side by side and aligned parallel to one another and which each have at least one printing nest (7), wherein the squeegee means (10) has a single printing screen (11), which extends over all printing nests (7) and which has a printing pattern for each printing nest (7), and wherein the squeegee means (10) has at least one squeegee (14), which can be moved over each printing nest (7) in order to print successively onto the substrates (16), which are arranged in the printing nests (7), wherein at least one sensor means (18) for detecting the position and/or alignment of a substrate (16) arranged on the respective printing nest (7) is assigned or can be assigned to each printing nest (7), wherein at least one controllable adjusting means (21) for aligning and/or positioning the respective substrate (16) and the printing screen (11) to one another is assigned to the printing table (2) and/or the squeegee means (10), and wherein a correcting of the alignment and/or position of the respective substrate (16) and of the printing screen (11) to one another takes place in that period of time, in which the squeegee (14) is moved from a substrate (16), which was printed onto previously, to a substrate (16), which is to be printed onto.

2. The printing device according to claim 1, **characterized in that** the squeegee means has at least one printing screen (11), which has a screen frame (12), which supports a screen (13).

3. The printing device according to any one of the preceding claims, **characterized in that** the adjusting means (21) has at least one controllable actuator for moving the printing table (2) and/or the printing screen (11).

4. The printing device according to any one of the preceding claims, **characterized in that** a control means (24) is connected to the sensor means (18) and to the at least one adjusting means (21) and is specifically made to align substrate (18) and printing screen (11) to one another by controlling the at least one actuator.

5. The printing device according to any one of the preceding claims, **characterized in that** the sensor means (18) has at least one camera means (23) for detecting the position and/or alignment of a substrate (16) on at least one of the printing nests (7).

6. The printing device according to any one of the preceding claims, **characterized in that** the sensor means (18) has a displaceable camera means (23), which can be moved to each printing nest (7) in order to successively detect the alignment and position of the substrates (16) of all printing nests (7).

7. The printing device according to any one of the preceding claims, **characterized in that** the sensor means (18) in each case has at least one, in particular several, stationary camera means (23) for each of the printing nests (7).

8. The printing device according to any one of the preceding claims, **characterized in that** the respective printing nest (7) has a lifting device (9), by means of which the substrate (16) to be printed onto can be raised in the direction of the printing screen (11).

9. The printing device according to any one of the preceding claims, **characterized in that** the camera means (23) is formed to be displaceable in such a way that it can be retracted between printing table (2) and printing screen (11) to detect the alignment and/or position of a substrate (16) and can be displaced next to printing table (2) and printing screen (11) to reach a non-use position.

10. The printing device according to any one of the preceding claims, **characterized in that** the respective printing nest (7) has fixing means for locking a substrate to be printed onto on the respective printing nest (7).

11. The printing device according to any one of the preceding claims, **characterized in that** the squeegee means (10) has a flooding means, which is formed to flood the squeegee means (10), in particular the printing screen (11) with a printing medium before a printing process is carried out by means of the movement of the squeegee (14).

12. A method for operating a printing device, in particular according to any one of claims 1 to 11, for printing onto substrates, in particular solar cells, wafers or printed circuit boards, comprising a squeegee means (10) and comprising at least one printing table (2), wherein the squeegee means (10) is arranged above the printing table (2), and wherein a substrate (16) to be printed onto is conveyed onto a printing nest (7), is printed onto, and is subsequently transported away from the printing nest (7), wherein the substrates (16) are each supplied along several conveying means (3,4,5), which are arranged side by side, to one of several printing nests (7), which are arranged side by side, are printed onto successively by means of a squeegee (14) of the squeegee means (10) and are removed, wherein the squeegee means (10) has a single printing screen (11), which extends over all printing nests (7) and which has a printing pattern for each printing nest (7), and wherein at least one sensor means (18) for detecting the position and/or alignment of a substrate (16) arranged on the respective printing nest (7) is assigned or can be assigned to each printing nest (7), wherein at least one controllable adjusting means (21) for aligning and/or positioning the respective substrate (16) and the printing screen (11) to one another is assigned to the printing table (2) and/or the squeegee means (10), and wherein an alignment and/or position of the respective substrate (16) and of the printing screen (11) to one another is corrected in that period of time, in which the squeegee (14) is moved from a substrate (16), which was printed onto previously, to a substrate (16), which is to be printed onto.

13. The method according to claim 12, **characterized in that** the substrates are initially printed onto successively by means of the squeegee means (10) **in that** the squeegee means (10) is initially flooded with a printing medium and the squeegee (14) is subsequently moved successively from an initial position in a direction over all printing nests (7) in order to carry out a printing process.

14. The method according to claim 13, **characterized in that** the squeegee (14) is subsequently moved back into the initial position over all printing nests (7).

15. The method according to claim 14, **characterized in that** the squeegee means (10) is flooded with printing medium again before the squeegee (14) is moved backwards, so that the squeegee (14) carries out a further printing process when being moved backwards.

16. The method according to claim 15, **characterized in that** the conveying means (3,4,5) are controlled to each transport a substrate (16), which has been printed onto, away out of the printing nest and to transport a substrate (16), which is to be printed onto, onto the printing nest (7) before the squeegee is moved backwards.

## Revendications

1. Dispositif d'impression (1) pour l'impression sur des substrats (16), en particulier des cellules solaires, des tranches ou des cartes de circuits imprimés, avec un moyen de raclage (10) et avec au moins une table d'impression (2), dans lequel le moyen de raclage (10) est disposé au-dessus de la table d'impression (2), et avec au moins un moyen de convoyage (3, 4, 5) au moyen duquel respectivement un substrat (16) peut être transporté sur un nid d'impression (7) au-dessous du moyen de raclage (10) et, une fois le processus d'impression effectué, en dehors du nid d'impression (7), dans lequel la table d'impression (2) comprend plusieurs moyens de convoyage (3, 4, 5) alignés les uns à côté des autres et parallèlement les uns aux autres, lesquels comprennent respectivement au moins un nid d'impression (7), dans lequel le moyen de raclage (10) comprend un unique tamis d'impression (11) qui s'étend par-dessus la totalité des nids d'impression (7), lequel tamis d'impression comprend un motif d'impression pour chaque nid d'impression (7), et dans lequel le moyen de raclage (10) comprend au moins un racloir (14) qui peut être déplacé par-dessus chaque nid d'impression (7) afin d'imprimer successivement sur les substrats (16) disposés dans les nids d'impression (7), dans lequel au moins un moyen de détection (18) est associé ou associable à chaque nid d'impression (7) pour l'enregistrement de la position et/ou de l'alignement d'un substrat (16) disposé sur le nid d'impression (7) respectif, dans lequel au moins un moyen d'ajustement (21) actionnable est associé à la table d'impression (2) et/ou au moyen de raclage (10) pour l'alignement et/ou le positionnement du substrat (16) respectif et du tamis d'impression (11) l'un par rapport à l'autre, et dans lequel une correction de l'alignement et/ou de la position du substrat (16) respectif et du tamis d'impression (11) l'un par rapport à l'autre s'effectue dans la période de temps dans laquelle le racloir (14) est déplacé d'un substrat (16) ayant précédemment subi une impression jusqu'à un substrat (16) destiné à subir une impression.

2. Dispositif d'impression selon la revendication 1, **caractérisé en ce que** le moyen de raclage comprend au moins un tamis d'impression (11), lequel comprend un cadre de tamis (12) qui porte un tamis (13).

3. Dispositif d'impression selon l'une des revendications précédentes, **caractérisé en ce que** le moyen d'ajustement (21) comprend au moins un actionneur actionnable pour le déplacement de la table d'impression (2) et/ou du tamis d'impression (11).

4. Dispositif d'impression selon l'une des revendications précédentes, **caractérisé en ce qu'**un moyen de commande (24) est relié au moyen de détection (18) et à l'au moins un moyen d'ajustement (21) et est spécialement agencé pour aligner le substrat (16) et le tamis d'impression (11) l'un par rapport à l'autre par actionnement de l'au moins un actionneur.

5. Dispositif d'impression selon l'une des revendications précédentes, **caractérisé en ce que** le moyen de détection (18) comprend au moins un moyen formant caméra (23) pour l'enregistrement de la position et/ou de l'alignement d'un substrat (16) sur au moins l'un des nids d'impression (7).

6. Dispositif d'impression selon l'une des revendications précédentes, **caractérisé en ce que** le moyen de détection (18) comprend un moyen formant caméra (23) déplaçable, lequel peut être déplacé vers chaque nid d'impression (7) afin d'enregistrer successivement l'alignement et la position des substrats (16) de la totalité des nids d'impression (7).

7. Dispositif d'impression selon l'une des revendications précédentes, **caractérisé en ce que** le moyen de détection (18) comprend pour chacun des nids d'impression (7) respectivement au moins un, en particulier plusieurs, moyens formant caméra (23) fixes.

8. Dispositif d'impression selon l'une des revendications précédentes, **caractérisé en ce que** le nid d'impression (7) respectif comprend un dispositif de levage (9) au moyen duquel le substrat (16) destiné à subir une impression peut être levé dans la direction du tamis d'impression (11).

9. Dispositif d'impression selon l'une des revendications précédentes, **caractérisé en ce que** le moyen formant caméra (23) est conçu déplaçable de telle sorte qu'il est rétractable pour l'enregistrement de l'alignement et/ou de la position d'un substrat (16) entre la table d'impression (2) et le tamis d'impression (11) et déplaçable pour atteindre une position de non-utilisation près de la table d'impression (2) et du tamis d'impression (11).

10. Dispositif d'impression selon l'une des revendications précédentes, **caractérisé en ce que** le nid d'impression (7) respectif comprend des moyens de fixation pour le blocage d'un substrat destiné à subir une impression sur le nid d'impression (7) respectif.

11. Dispositif d'impression selon l'une des revendications précédentes, **caractérisé en ce que** le moyen de raclage (10) comprend un moyen d'inondation qui est conçu pour inonder le moyen de raclage (10), en particulier le tamis d'impression (11), avec un milieu d'impression avant qu'un processus d'impression soit mis en œuvre par le déplacement du racloir (14).

12. Procédé pour le fonctionnement d'un dispositif d'impression, en particulier selon l'une des revendications 1 à 11, pour l'impression sur des substrats, en particulier des cellules solaires, des tranches ou des cartes de circuits imprimés, avec un moyen de raclage (10) et avec au moins une table d'impression (2), dans lequel le moyen de raclage (10) est disposé au-dessus de la table d'impression (2), et dans lequel un substrat (16) destiné à subir une impression est convoyé sur un nid d'impression (7), subit une impression et est ensuite transporté à l'écart du nid d'impression (7), dans lequel les substrats (16) sont acheminés le long de plusieurs moyens de convoyage (3, 4, 5) disposés les uns à côté des autres respectivement jusqu'à l'un de plusieurs nids d'impression (7) disposés les uns à côté des autres, subissent successivement une impression par le biais d'un racloir (14) du moyen de raclage (10) et sont évacués, dans lequel le moyen de raclage (10) comprend un unique tamis d'impression (11) qui s'étend par-dessus la totalité des nids d'impression (7), lequel tamis d'impression comprend un motif d'impression pour chaque nid d'impression (7), et dans lequel au moins un moyen de détection (18) est associé ou associable à chaque nid d'impression (7) pour l'enregistrement de la position et/ou de l'alignement d'un substrat (16) disposé sur le nid d'impression (7) respectif, dans lequel au moins un moyen d'ajustement (21) actionnable est associé à la table d'impression (2) et/ou au moyen de raclage (10) pour l'alignement et/ou le positionnement du substrat (16) respectif et du tamis d'impression (11) l'un par rapport à l'autre, et dans lequel un alignement et/ou une position du substrat (16) respectif et du tamis d'impression (11) l'un par rapport à l'autre sont corrigés par le biais du moyen d'ajustement (21) dans la période de temps dans laquelle le racloir (14) est déplacé d'un substrat (16) ayant précédemment subi une impression jusqu'à un substrat (16) destiné à subir une impression.

13. Procédé selon la revendication 12, **caractérisé en ce que** les substrats subissent tout d'abord successivement une impression au moyen du moyen de raclage (10), du fait que le moyen de raclage (10) est tout d'abord inondé avec un milieu d'impression et ensuite que le racloir (14) est déplacé d'une position de départ dans une direction par-dessus la totalité des nids d'impression (7) successivement pour la mise en œuvre d'un processus d'impression.

14. Procédé selon la revendication 13, **caractérisé en ce que** le racloir (14) est ensuite reculé dans la position de départ par-dessus la totalité des nids d'impression (7).

15. Procédé selon la revendication 14, **caractérisé en ce qu'**avant que le racloir (14) soit reculé, le moyen de raclage (10) est à nouveau inondé avec du milieu d'impression, de sorte que le racloir (14) met en œuvre un processus d'impression supplémentaire lors du recul.

16. Procédé selon la revendication 15, **caractérisé en ce que** les moyens de convoyage (3, 4, 5) sont actionnés pour transporter respectivement un substrat (16) ayant subi une impression en dehors du nid d'impression et pour transporter un substrat (16) destiné à subir une impression sur le nid d'impression (7) avant que le racloir soit reculé.
